# EUROPÄISCHE PATENTSCHRIFT

(11) **EP 3 371 823 B1**
(45) Veröffentlichungstag und Bekanntmachung des Hinweises auf die Patenterteilung: **21.06.2023**
(21) Anmeldenummer: 16787425.4
(22) Anmeldetag: 25.10.2016
(51) Int. Cl.: H01L 21/683, B29C 63/00, B32B 7/06, H01L 23/00, H01L 23/31, B32B 27/08, B32B 27/06, B32B 7/12, B32B 3/30, B32B 27/28, B32B 27/16, B32B 9/04, B32B 27/30, B32B 27/38, B32B 27/34, H05K 3/00, G03F 7/00

(54) **VERFAHREN ZUR BEHANDLUNG VON MILLIMETER-, MIKROMETER- ODER NANOMETERSTRUKTUREN AUF EINER OBERFLÄCHE EINES SUBSTRATS**
METHOD FOR TREATING MILLIMETER, MICROMETER OR NANOMETER STRUCTURES ON A SURFACE OF A SUBSTRATE
PROCÉDÉ DE TRAITEMENT DE STRUCTURES DE TAILLE MILLIMÉTRIQUE, MICROMÉTRIQUE OU NANOMÉTRIQUE SUR UNE SURFACE D'UN SUBSTRAT

(30) Priorität: 05.11.2015 DE 102015118991
(43) Veröffentlichungstag der Anmeldung: 12.09.2018
(73) Patentinhaber: EV Group E. Thallner GmbH, 4782 St. Florian am Inn (AT)
(72) Erfinder: MITTENDORFER, Gerald, 4975 Stuben (AT)
(74) Vertreter: Schneider, Sascha
(86) Internationale Anmeldenummer: PCT/EP2016/075638
(87) Internationale Veröffentlichungsnummer: WO 2017/076689

(56) Entgegenhaltungen:
- DE-T2- 69 208 629
- JP-A- S6 242 426
- JP-A- 2001 102 330
- JP-A- 2010 165 963
- US-A- 6 051 298
- US-A1- 2012 322 241
- US-A1- 2014 116 618
- US-A1- 2015 013 917

## Beschreibung

Im Stand der Technik existieren unzählige Verfahren um die Oberfläche von Substraten, insbesondere Wafern, zu behandeln. Ein sehr wichtiger Aspekt der Bearbeitung von Substraten stellt die beidseitige Bearbeitung dar. Bei einer beidseitigen Bearbeitung werden beide Seiten des Substrats, insbesondere nacheinander, behandelt. Dabei ist es notwendig, die Fixierungsseite, d.h. die Seite die nicht prozessiert wird, entsprechend zu schützen. Der Schutz ist notwendig, um die Substratseite nicht durch die Fixierung zu zerstören. Im Stand der Technik existieren viele Materialien, die für den Schutz einer Substratseite während der Fixierung auf einem Probenhalter verwendet werden. Bei diesen Materialien handelt es sich vorzugsweise um Polymere, die nach der Auftragung auf die Substratoberseite durch chemische und/oder physikalische Prozess in einen ersten Zustand gebracht werden, der die Strukturen der fixierten Substratseite optimal schützt. US 2012322241A1 offenbart ein Verfahren zum Zerschneiden von Substraten mit einer Vielzahl an ICs. JP 2001102330A offenbart ein Verfahren zur Herstellung von Substraten. JPS6242426A offenbart ein Verfahren zur Bildung einer Schutzschicht.

WO2014/037044-A1 offenbart einen Strukturstempel mit einer mikro- oder nanostrukturierten Stempelfläche zur Prägung einer Prägestruktur auf einer Prägefläche, einen Rahmen zum Einspannen des Stempels, eine Prägematerialaufnahme und einen Prägeelementantrieb zur Bewegung eines, Prägeelements entlang des Strukturstempels.

Das Problem mit den Materialien besteht in deren Entfernung. Die meisten Materialien werden durch chemische Prozesse ausgehärtet, insbesondere vernetzt. Dadurch entsteht eine gewisse Tendenz, an den Strukturen der Substratoberfläche festzuhaften. Des Weiteren ist eine Entfernung der Materialien aus den Zwischenräumen der Strukturen umso schwieriger, je langkettiger die Polymere, je größer der Haftfestigkeit und je hochviskoser das Polymer ist.

Es ist daher die Aufgabe der vorliegenden Erfindung ein Verfahren anzugeben, mit dem die Strukturen an der Oberfläche des Substrats optimal geschützt werden können, in einem späteren Zeitpunkt aber eine möglichst einfache Entfernung erfolgen kann.

Diese Aufgabe wird mit dem Gegenstand der nebengeordneten Patentansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Zeichnungen angegebenen Merkmalen. Bei Wertebereichen sollen auch innerhalb der genannten Grenzen liegende Werte als Grenzwerte offenbart und in beliebiger Kombination beanspruchbar sein.

Erfindungsgemäß wird ein Verfahren zur Behandlung eines Substrats mit Millimeter- und/oder Mikrometer- und/oder Nanometerstrukturen vorgeschlagen, wobei auf die Strukturen mindestens ein Schutzmaterial aufgebracht wird, wobei das mindestens eine Schutzmaterial in einem Lösungsmittel lösbar ist.

Der erfindungsgemäße Prozess erlaubt den Schutz einer strukturierten, insbesondere durch 3D Strukturen versehenen, Oberfläche. Die strukturierte Oberfläche wurde erfindungsgemäß durch einen Imprintprozess erzeugt. Denkbar wäre aber auch die Erzeugung durch Heißprägeprozesse, photolithographische Prozesse, Ätzprozesse etc.

An der Substratoberfläche des Substrats befinden sich eine oder mehrere schützenswerte Strukturen. Der Einfachheit halber wird im Folgenden zumeist im Plural von Strukturen gesprochen. Bei den Strukturen kann es sich um Mikrochips, MEMs, Kavitäten, LEDs, Speicher insbesondere aber um Prägestrukturen handeln. Die Strukturen sind mit einem erfindungsgemäßen Schutzmaterial beschichtet.

Der erfindungsgemäße Gedanke besteht in der Verwendung einer Schutzmaterial-Lösungsmittelkombination. Die Schutzmaterial-Lösungsmittelkombination muss so ausgelegt sein, dass sich nach dem Prinzip "Ähnliches mischt sich in Ähnlichem", eine Lösung des Schutzmaterials im Lösungsmittel in optimaler Art und Weise ergibt. Das Lösungsmittel wird dabei als Reinigungsmittel verwendet um das Schutzmaterial nach einer vorgegebenen Anzahl von Prozessschritten von einer Substratoberfläche zu entfernen.

Das Schutzmaterial schützt die Strukturen durch alle Arten von Belastungen, die auf der Substratoberfläche und/oder der gegenüberliegenden, zweiten Substratoberfläche auftreten. Dazu zählen beispielsweise Fixierprozesse, Ätzprozesse, Schleifprozesse, Polierprozesse, Strukturierungsprozesse, insbesondere Imprintprozesse. In einer ganz besonderen, erfindungsgemäßen Ausführungsform werden auf der zweiten Substratoberfläche wiederum Strukturen geprägt, sodass man ein doppelseitig geprägtes Substrat erhält.

Nach der Bearbeitung der Strukturen der zweiten Substratoberfläche kann wiederum eine erfindungsgemäße Beschichtung zum Schutz der Strukturen erfolgen, sofern das notwendig ist. Eine Notwendigkeit ergibt sich vor allem bei einem Transport über lange, insbesondere über verunreinigte Strecken. Das erfindungsgemäße Schutzmaterial dient daher nicht nur als mechanischer Stabilisator, sondern auch als Schutzschicht für, in der Atmosphäre und/oder Umgebung vorkommende Medien, insbesondere Fluide, noch spezifischer Flüssigkeiten oder Gase, insbesondere Sauerstoff.

Gemäß einer vorteilhaften Weiterbildung ist es vorgesehen, dass das mindestens eine Schutzmaterial als mindestens eine Schutzschicht auf den Strukturen angeordnet wird, wobei bevorzugt das mindestens eine Schutzmaterial vollständig die Strukturen überdeckt. Dadurch ist vorteilhaft ein verbesserter Schutz der Strukturen möglich.

Gemäß einer anderen vorteilhaften Weiterbildung ist es vorgesehen, dass das mindestens eine Schutzmaterial durch Schleuderbelackung, Sprühbelackung, Laminierung und/oder Tauchen aufgebracht wird. Dadurch ist vorteilhaft erreichbar, dass das Schutzmaterial besonders effizient aufgebracht werden kann.

Gemäß einer anderen vorteilhaften Weiterbildung ist es vorgesehen, dass das mindestens eine Schutzmaterial nach dem Aufbringen chemisch und/oder physikalisch modifiziert wird, wobei diese Modifikation insbesondere eine Härtung, eine Viskositätserhöhung und/oder eine Elastizitätssteigerung des mindestens einen Schutzmaterials umfasst. Dadurch kann vorteilhaft ein verbesserter Schutz der Strukturen erreicht werden. Die so erfolgte Modifizierung ermöglicht erfindungsgemäß immer noch eine möglichst effiziente und einfache Entfernung der Schutzschicht.

Gemäß einer anderen vorteilhaften Weiterbildung ist es vorgesehen, dass auf ein erstes aufgebrachtes Schutzmaterial ein zweites, insbesondere vom Schutzmaterial unterschiedliches, Schutzmaterial aufgebracht wird. Dadurch können vorteilhaft Schutzmaterialien mit unterschiedlichen Eigenschaften verwendet werden, wodurch der Schutz der Strukturen noch weiter verbessert werden kann.

Gemäß einer anderen vorteilhaften Weiterbildung ist es vorgesehen, dass mehrere, insbesondere unterschiedliche Schutzmaterialien aufweisende, übereinander angeordnete Schutzschichten über den Strukturen angeordnet werden. Dadurch kann vorteilhaft ein verbesserter Schutz der Strukturen erreicht werden.

Gemäß einer anderen vorteilhaften Weiterbildung ist es vorgesehen, dass das mindestens eine Schutzmaterial einen der folgenden Stoffe oder ein Gemisch der folgenden Stoffe umfasst:
- Paraffine,insbesondere
   ∘ Petrolatum
   ∘ Wachse
      ▪ Ceresin
- Polymere, insbesondere
   ∘ Photolacke allgemein
   ∘ Poly(methylmethacrylate)
   ∘ Poly(methylglutarimide)
   ∘ Phenolformaldehydeharze, insbesondere
      ▪ Bakelit
   ∘ Epoxide, insbesondere
      ▪ SU-8
   ∘ Polyimide
   ∘ Polyamide
   ∘ Silane
   ∘ Silikone
   ∘ PDMS (Schutzfolie und abziehen)
   ∘ PFPE
   ∘ Akrylate

Gemäß einer anderen vorteilhaften Weiterbildung ist es vorgesehen, dass das mindestens eine Schutzmaterial einen der folgenden Stoffe oder ein Gemisch der folgenden Stoffe umfasst:
- Polyvinylalkohol
- Polyether, insbesondere
   ∘ Polyethylenglykol
- Celluloseether
- Poly(2-ethyl-2-oxazoline)
- Alkohole, insbesondere
   ∘ Glycerin, insbesondere
      ▪ Fette, insbesondere
         - Triacylglycerine
- Zucker
- Carbonsäureverbindungen in Kunststoffen
- Benzotriazol

Gemäß einer anderen vorteilhaften Weiterbildung ist es vorgesehen, dass das mindestens eine Schutzmaterial durch eines der folgenden Lösungsmittel oder durch ein Lösungsmittelgemisch der folgenden Lösungsmittel lösbar ist:
- Alkane
- Alkene
- Alkine
- Aromaten, insbesondere
   ∘ Benzol
- Carbonsäureester
- Ether, insbesondere
   ∘ Diethylether
- Tetramethylsilan
- Tetrachlorwasserstoff
- Kohlenstoffdisulfid
- Benzin
- Chloroform
- Gase, insbesondere
   ∘ Kohlenmonoxid

Gemäß einer anderen vorteilhaften Weiterbildung ist es vorgesehen, dass das mindestens eine Schutzmaterial durch eines der folgenden Lösungsmittel oder durch ein Lösungsmittelgemisch der folgenden Lösungsmittel lösbar ist:
- Wasser
- Alkohole, insbesondere
   ∘ Methanol, Ethanol
- Ketone, insbesondere
   ∘ Aceton
- Amine, insbesondere
   ∘ Primäre und sekundäre Amine
- Lactone
- Lactame
- Nitrile
- Nitroverbindungen
- Tertiäre Carbonsäureamide
- Harnstoffderivate
- Sulfoxide
- Sulfone, insbesondere
   ∘ Sulfolan
- Kohlensäureester, insbesondere
   ∘ Dimethylcarbonat
   ∘ Ethylencarbonat
- Säuren, insbesondere
   ∘ Mineralsäuren, insbesondere
      ▪ Schwefelsäure
      ▪ Halogenwasserstoffsäuren
   ∘ Organische Säuren, insbesondere
      ▪ Carbonsäuren, insbesondere
         - Ameisensäure, Essigsäure
- Basen, insbesondere
   ∘ NaOH, KOH
- Gase
   ∘ Wasserstoff
   ∘ Sauerstoff
   ∘ Stickstoff

Die Verwendung von Gasen erlaubt insbesondere die Zersetzung und damit Entfernung des erfindungsgemäßen Schutzmaterials durch einen Reduktions- oder Oxidationsprozess.

Ein weiterer Gegenstand der vorliegenden Erfindung betrifft eine Anlage zur Behandlung eines Substrats, insbesondere zur Durchführung eines Verfahrens gemäß einer der vorhergehenden Ausführungsformen, mit Millimeter-, Mikrometer- und/oder Nanometerstrukturen, aufweisend
a) eine Fixiereinrichtung zur Fixierung des Substrats,
b) ein Aufbringmittel, insbesondere eine Düseneinrichtung mit einer oder mehreren Düsen und/oder ein Tauchbad, zur Aufbringung mindestens eines Schutzmaterials auf die Strukturen, wobei das mindestens eine Schutzmaterial in einem Lösungsmittel lösbar ist.

Ein anderer Gegenstand der vorliegenden Erfindung betrifft ein Produkt, insbesondere hergestellt mit einem Verfahren und/oder einer Anlage gemäß einer der vorhergehenden Ausführungsformen, aufweisend ein Substrat mit Millimeter und/oder Mikrometer und/oder Nanometerstrukturen und mindestens eine Beschichtung auf den Strukturen aus mindestens einem Schutzmaterial, wobei das mindestens eine Schutzmaterial durch ein Lösungsmittel lösbar ist.

Ein anderer Gegenstand der vorliegenden Erfindung betrifft ein Verfahren zur Bearbeitung eines Substrats, insbesondere einer Folie, aufweisend mindestens die folgenden Schritte:
a) Abgabe des Substrats von einer Abgabeeinheit,
b) Aufbringung und/oder Anordnung, insbesondere beidseitig des Substrats, von Millimeter und/oder Mikrometer und/oder Nanometerstrukturen auf dem Substrat,
c) Aufbringung, insbesondere beidseitig des Substrats, mindestens eines Schutzmaterials, insbesondere mit einem Verfahren gemäß einer der vorhergehenden Ausführungsformen, auf die Strukturen, wobei das mindestens eine Schutzmaterial in einem Lösungsmittel lösbar ist,
d) Aufnahme des Substrats von einer Speichereinheit.

Beschrieben sei ebenfalls eine Anlage zur Bearbeitung eines Substrats, insbesondere einer Folie, aufweisend:
a) eine Abgabeeinheit zur Abgabe des Substrats,
b) eine Bearbeitungseinheit zur Aufbringung und/oder Anordnung von Millimeter und/oder Mikrometer und/oder Nanometerstrukturen auf dem Substrat,
c) ein Aufbringmittel zur Aufbringung mindestens eines Schutzmaterials, insbesondere mit einem Verfahren gemäß einer der vorhergehenden Ausführungsformen, auf die Strukturen, wobei das mindestens eine Schutzmaterial in einem Lösungsmittel lösbar ist,
d) eine Speichereinheit zur Aufnahme des Substrats.

In einer weiteren erfindungsgemäßen Ausführungsform handelt es sich bei dem erfindungsgemäßen Schutzmaterial um ein unpolares Material. Erfindungsgemäß hat das Lösungsmittel vorzugsweise ebenfalls unpolar zu sein.

In einer weiteren, besonders bevorzugten Ausführungsform handelt es sich bei dem erfindungsgemäßen Schutzschichtmaterial um ein polares Material.

Erfindungsgemäß hat das Lösungsmittel vorzugsweise ebenfalls polar zu sein. In einer ganz besonders erfindungsgemäßen Ausführungsform handelt es sich bei dem erfindungsgemäßen Schutzmaterial um Polyvinylalkohol und bei dem erfindungsgemäßen Lösungsmittel um Wasser.

In einer Erweiterung der genannten erfindungsgemäßen Ausführungsformen kann statt einem Lösungsmittel eine Lösungsmittelmischung verwendet werden. Die Lösungsmittelmischung besteht dabei aus einer Kombination mindestens zweier oben genannter Lösungsmittel. Insbesondere ist eines der Lösungsmittel im Exzess vorhanden. Der Massenanteil des im Exzess vorkommenden Lösungsmittels beträgt dabei mehr als 50%, vorzugsweise mehr als 60%, noch bevorzugter mehr als 70%, am bevorzugtesten mehr als 80%, am allerbevorzugtesten mehr als 90%.

In einer Erweiterung der genannten erfindungsgemäßen Ausführungsformen kann statt einem Schutzmaterial eine Schutzmaterialmischung verwendet werden, insbesondere eine Schutzmaterialmischung, bei der jedes einzelne Schutzmaterial selektiv auf ein spezifisches Lösungsmittel reagiert. Die Schutzmaterialmischung besteht dabei aus einer Kombination mindestens zweier oben genannter Schutzmaterialien. Insbesondere ist eines der Schutzmaterialien im Exzess vorhanden. Der Massenanteil des im Exzess vorkommenden Schutzmaterials beträgt dabei mehr als 50%, vorzugsweise mehr als 60%, noch bevorzugter mehr als 70%, am bevorzugtesten mehr als 80%, am allerbevorzugtesten mehr als 90%.

In einer Erweiterung der genannten erfindungsgemäßen Ausführungsformen können mehrere Schichten unterschiedlicher Schutzmaterialien auf eine Substratoberfläche aufgetragen werden. Diese Schutzmaterialkombinationen haben vor allem den Vorteil, dass unterschiedliche Schutzmaterialien unterschiedliche physikalische und/oder chemische Eigenschaften aufweisen. In einer ersten besonders bevorzugten erfindungsgemäßen Ausführungsform wird zuerst eine Schutzschicht aufgebracht, die über ausreichende elastische Eigenschaften verfügt, um die, auf der Substratoberfläche vorhandenen Strukturen, gegen mechanische Belastung zu schützen. Über der ersten Schutzschicht befindet sich eine zweite, insbesondere gegen chemische Angriffe resistente, zweite Schutzschicht.

Die elastischen Eigenschaften des erfindungsgemäßen Schutzmaterials werden durch den E-Modul bestimmt. Der E-Modul liegt dabei zwischen 1 GPa und 1000 GPa, bevorzugt zwischen 1 GPa und 500 GPa, mit größerem Vorzug zwischen 1 GPa und 100 GPa, mit größtem Vorzug zwischen 1 GPa und 50 GPa, mit allergrößtem Vorzug zwischen 1 GPa und 20 GPa. Der E-Modul von Polyamiden liegt beispielsweise zwischen 3 und 6 GPa.

Das erfindungsgemäße Schutzmaterial muss eine Adhäsion zu den zu schützenden Strukturen besitzen, welche eine genügend hohe Haftfestigkeit des erfindungsgemäßen Schutzmaterials gestattet. Die Adhäsion wird vorzugsweise über die Energie pro Flächeneinheit definiert, die notwendig ist, um zwei miteinander verbundene Oberflächen voneinander zu trennen. Die Energie wird dabei in J/m2 angegeben. Die Energie pro Einheitsfläche ist dabei größer als 0.0001 J/m2, mit Vorzug größer als 0.001 J/m2, mit größerem Vorzug größer als 0.01 J/m2, mit größtem Vorzug größer als 0.1 J/m2, mit allergrößtem Vorzug größer als 1.0 J/m2, am bevorzugtesten größer als 2.5 J/m2.

Die Oberflächenrauhigkeit des erfindungsgemäßen Schutzmaterials muss möglichst gering sein, damit das erzeugte Produkt über die Schutzmaterialoberfläche möglichst optimal auf einem Probenhalter fixiert werden kann. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit ist dabei kleiner als 100 µm, vorzugsweise kleiner als 10 µm, noch bevorzugter kleiner als 1 µm, am bevorzugtesten kleiner als 100nm, am allerbevorzugtesten kleiner als 10nm.

In einer beispielhaften erfindungsgemäßen Ausführungsform handelt es sich bei dem Substrat um einen Wafer. Die Wafer sind genormte Substrate mit wohldefinierten, standardisierten Durchmessern. Die Substrate können allerdings im Allgemeinen jede beliebige Form besitzen. Die Durchmesser der Substrate können im Allgemeinen jede beliebige Größe annehmen, besitzen aber meistens eine der genormten Durchmesser von 1 Zoll, 2 Zoll, 3 Zoll, 4 Zoll, 5 Zoll, 6 Zoll, 8 Zoll, 12 Zoll und 18 Zoll bzw. 25.4 mm, 50.8 mm, 76.2 mm, 100 mm, 125 mm, 150 mm, 200 mm, 300 mm, 450 mm.

In einer speziellen Ausführungsform kann es sich bei dem Substrat auch um einen Stempel, insbesondere einen Weichstempel, handeln, dessen Strukturen, zumindest zeitweise, geschützt werden müssen. Denkbar wäre beispielsweise, dass die Stempelstruktur eines Stempels für einen Transport geschützt werden muss.

Die Substrate werden vorwiegend in Modulen zur Bearbeitung von Wafern prozessiert, daher in
- Belackungsanlagen, insbesondere
   ∘ Schleuderbelackungsanlagen
   ∘ Sprühbelackungsanlagen
- Bondern, insbesondere
   ∘ Fusionsbondern
   ∘ Thermokompressionsbondern
   ∘ Anodischen Bondern
- Dicern
- Grindern
- Alignern
- Rollenimprintanlagen, insbesondere aus WO2014/037044A1
- Etc.

Die Substrate sind dabei weitestgehend auf Probenhaltern fixiert. Im Falle einer Auftragung durch eine Schleuderbelackung, handelt es sich bei dem Probenhalter vorzugsweise um einen drehbar gelagerten Probenhalter. Das Schutzmaterial wird dabei mit Hilfe eines Aufbringmittels auf die Strukturen abgeschieden. Bei dem Aufbringmittel handelt es sich um eine Düse, einen Schlauch, ein Rohr oder jede andere beliebige Zuführung, die das erfindungsgemäße Schutzmaterial abscheiden kann.

In einer anderen erfindungsgemäßen Ausführungsform handelt es sich bei dem Substrat um eine Folie. Die breite der Folie ist dabei größer als 10 mm, vorzugsweise größer als 100 mm, noch bevorzugter größer als 500 mm, am bevorzugtesten größer als 1000 mm, noch bevorzugter größer als 1500 mm. Die Folie besitzt eine Dicke kleiner als 2 mm, bevorzugter kleiner als 1 mm, noch bevorzugter kleiner als 0.5 mm, am bevorzugtesten kleiner als 0.1 mm, am allerbevorzugtesten kleiner als 0.01 mm.

Die Folien werden vorwiegend in sogenannten Rolle-zu-Rolle Anlagen prozessiert. Eine Rolle-zu-Rolle Anlage besitzt mindestens eine Ladeeinheit, welcher eine aufgewickelte Folie zugeführt wird. Die Rolle-zu-Rolle Anlage führt die Folie danach über mindestens eine erste Prozesssiereinheit, in der eine Bearbeitung mindestens einer Folienoberfläche durchgeführt wird. Insbesondere können sogar zwei Folienoberflächen gleichzeitig prozessiert, insbesondere durch Imprintprozesse modifiziert werden. Die Folie wird danach über eine weitere Prozesssiereinheit, in der die erfindungsgemäße Beschichtung erfolgt, geführt. Danach kann entweder eine Weiterprozessierung einer noch nicht geschützten Folienoberfläche erfolgen oder die Folie wird auf einer Rolle am Ende der Rolle-zu-Rolle Anlage wieder aufgewickelt. Erfindungsgemäß kann der Transport der Folie mit der geschützten Folienoberfläche erfolgen, ohne die Strukturen zu beschädigen. In einer weiteren Prozessieranlage, insbesondere einer weiteren, zweiten Rolle-zu-Rolle Anlage, kann eine Entfernung der Schutzschicht erfolgen. Denkbar ist auch, dass die Folie zuerst in kleinere Einheiten, insbesondere auf Wafergröße und Form, zugeschnitten wird und eine Entfernung des Schutzmaterials erst nach dem Zerschneiden erfolgt.

Im weiteren Verlauf der Patentschrift wird allgemein von Substraten gesprochen. Insbesondere beziehen sich die erfindungsgemäßen Ausführungsformen auf Wafer.

In einem ersten Schritt eines beispielhaften erfindungsgemäßen Verfahrens erfolgt die Fixierung eines Substrats mit seiner zweiten, insbesondere ebenen, Substratoberfläche an der Oberfläche eines Probenhalters. Der Fixierung ging insbesondere eine Prozessierung der ersten Substratoberfläche voraus. Das Substrat ist dabei vorzugsweise mit seiner der ersten Substratoberfläche gegenüberliegenden zweiten Substratoberfläche auf einem Probenhalter fixiert. Die Fixierung erfolgt dabei mit Hilfe von Fixiermitteln. Bei den Fixiermitteln handelt es sich vorzugsweise um eine Vakuumfixierung. Denkbar sind auch mechanische Fixierungen, elektrostatische Fixierungen, magnetische Fixierungen oder Fixierungen mittels, insbesondere schaltbarer, adhäsiver Oberflächen. Die schützenswerten, insbesondere geprägten, Strukturen konnten insbesondere direkt nach der Fixierung des Substrats auf dem Probenhalter prozessiert und hergestellt werden.

In einem zweiten Prozessschritt erfolgt eine Aufbringung eines erfindungsgemäßen Schutzmaterials auf die erste Substratoberfläche. Die Aufbringung des erfindungsgemäßen Schutzmaterials kann durch eines der folgenden Verfahren erfolgen
- Schleuderbelackung
- Sprühbelackung
- Laminierung
- Tauchen

In einem dritten, optionalen, Prozessschritt, kann eine chemische und/oder physikalische Modifikation des erfindungsgemäßen Schutzmaterials erfolgen, welches die chemischen und/oder physikalischen Eigenschaften so verändert, dass ein erfindungsgemäß verbesserter Schutz der Strukturen der ersten Substratoberfläche ermöglich wird. Bei den Modifikationen kann es sich insbesondere um eines oder mehrere der folgenden Verfahren handeln
- Härten, insbesondere durch
   ∘ Vernetzung der Polymere, insbesondere durch
      ▪ Elektromagnetische Wellen, insbesondere durch,
         - UV Licht
      ▪ Thermische Energie
      ▪ Gase, insbesondere
         - Atmosphärengase
      ▪ Dämpfe
- Viskositätserhöhung, insbesondere durch
   ∘ Vernetzung der Polymere, insbesondere durch
      ▪ Elektromagnetische Wellen, insbesondere durch,
         - UV Licht
      ▪ Thermische Energie
   ∘ Verdampfen des Lösungsmittels
- Elastizitätssteigerung, insbesondere durch
   ∘ Vernetzung der Polymere, insbesondere durch
      ▪ Elektromagnetische Wellen, insbesondere durch,
         - UV Licht
      ▪ Thermische Energie

Der Härtungsprozess erfolgt durch elektromagnetische Strahlung, insbesondere durch UV Licht und/oder durch die Einwirkung von Wärmestrahlung. Die elektromagnetische Strahlung besitzt eine Wellenlänge im Bereich zwischen 10nm und 2000nm, mit Vorzug zwischen 10nm und 1500nm, mit größerem Vorzug zwischen 10nm und 1000nm, mit allergrößtem Vorzug zwischen 10nm und 500nm, mit allergrößtem Vorzug zwischen 10nm und 400nm. Eine Wärmebehandlung findet bei weniger als 750°C, vorzugsweise bei weniger als 500°C, noch bevorzugter bei weniger als 250°C, am bevorzugtesten bei weniger als 100°C, am allerbevorzugtesten bei weniger als 50°C statt. Eine Wärmebehandlung erfolgt vorzugsweise über Wärmeleitung durch den Probenhalter. Denkbar ist allerdings auch eine Erwärmung der umgebenden Atmosphäre oder eine Kombination daraus. Durch den optionalen, erfindungsgemäßen dritten Prozessschritt, wird das erfindungsgemäße Schutzmaterial so modifiziert, dass es insbesondere einer mechanischen Beanspruchung, insbesondere einer Normalkraft bzw. einem Normaldruck, standhält. Ein weiterer erfindungsgemäßer Gedanke besteht vor allem darin, dass das erfindungsgemäße Schutzmaterial die mechanische Beanspruchung nicht vollständig auf die von ihm umgebenden Strukturen weiterleitet sondern als elastisches Federelement die mechanische Beanspruchung weitestgehend von den Strukturen der ersten Substratoberfläche fernhält. Ein weiterer erfindungsgemäßer Aspekt des erfindungsgemäßen Schutzmaterial ist seine schützende Eigenschaft gegen Chemikalien, insbesondere Flüssigkeiten und/oder Gase bzw. Flüssigkeits- und/oder Gasgemischen. Insbesondere sollte das erfindungsgemäße Schutzmaterial Säure und/oder Basenbeständig sein und eine Oxidation der Strukturen der ersten Substratoberfläche verhindern.

In einem vierten Prozessschritt wird das Substrat mit der geschützten ersten Substratoberfläche an der Oberfläche eines, insbesondere zweiten Probenhalters, fixiert. Danach erfolgt die Prozessierung der zweiten Seite des Substrates. Insbesondere handelt es sich dabei wiederum um die Erzeugung von Strukturen durch einen Prägeprozess.

Sollte die prozessierte zweite Seite ebenfalls schützenswert sein, insbesondere wenn ein Transport der prozessierten Substrate über lange Strecken und/oder aggressive Atmosphären erfolgt, dann wird auch die zweite Seite mit dem Schutzmaterial beschichtet. Dabei kommt vorzugsweise dieselbe Beschichtungstechnik zum Einsatz wie für die Beschichtung der ersten Substratseite.

In einem weiteren Prozessschritt können ein Transport und/oder eine Speicherung des gesamten Produkts erfolgen.

In einem letzten Prozessschritt erfolgt die Entfernung des erfindungsgemäßen Schutzmaterials mit einem entsprechenden Lösungsmittel. Erfindungsgemäß erfolgt das insbesondere durch rein nasschemische Behandlung. Der erfindungsgemäße Gedanke besteht vor allem darin, ausschließlich Schutzmaterial-Lösungsmittelkombinationen zu verwenden, bei denen die Entfernung des Schutzmaterials ohne zusätzliche Chemikalien, Wärme oder Bestrahlung, insbesondere sogar nur bei Raumtemperatur, erfolgt. Der erfindungsgemäße Gedanke besteht vor allem darin, dass die Schutzmaterial-Lösungsmittelkombination so aufeinander abgestimmt ist, dass der polare bzw. unpolare Charakter übereinstimmt, daher entweder beide polare oder beide unpolare Materialien darstellen. In der bevorzugtesten erfindungsgemäßen Ausführungsform verwendet man als Schutzmaterial Polyvinylalkohol und als Lösungsmittel Wasser.

### Prozessfluss eines Foliensubstrats

In einem erfindungsgemäßen ersten Prozessschritt erfolgt die Abwicklung eines Foliensubstrats von einer ersten Speichereinheit, insbesondere einer Rolle.

In einem erfindungsgemäßen zweiten Prozessschritt erfolgt die Bearbeitung, insbesondere Strukturierung einer ersten Substratfolienoberfläche. Bei der Strukturierung handelt es sich insbesondere um eine Prägung, insbesondere durch eine oder mehrere Prägerollen. Die Bearbeitung, insbesondere die Prägung kann ein- oder zweiseitig erfolgen.

In einem erfindungsgemäßen dritten Prozessschritt erfolgt der erfindungsgemäße Schutz der strukturierten ersten Substratfolienoberfläche durch das erfindungsgemäße Schutzmaterial. Das erfindungsgemäße Schutzmaterial wird entweder durch eine Sprühbelackung aufgetragen oder man leitet die gesamte Folie durch ein Tauchbad.

In einem erfindungsgemäß letzten Prozessschritt erfolgt eine Speicherung der Folie, insbesondere auf einer weiteren Rolle. Denkbar ist auch, dass die Folie direkt zerschnitten und weiterverarbeitet wird.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine erste erfindungsgemäße Ausführungsform eines Produkts mit einem Schutzmaterial auf einer Substratoberfläche eines Wafers,
- Figur 2: eine zweite erfindungsgemäße Ausführungsform eines Produkts mit einem Schutzmaterial auf einer Substratoberfläche einer Folie,
- Figur 3: eine dritte erfindungsgemäße Ausführungsform eines Produkts mit zwei Schutzmaterialien auf einer Substratoberfläche eines Wafers,
- Figur 4a: ein erster Prozessschritt eines beispielhaften erfindungsgemäßen Prozesses,
- Figur 4b: ein zweiter Prozessschritt eines beispielhaften erfindungsgemäßen Prozesses,
- Figur 4c: ein dritter, optionaler, Prozessschritt eines beispielhaften erfindungsgemäßen Prozesses,
- Figur 4d: ein vierter Prozessschritt eines beispielhaften erfindungsgemäßen Prozesses,
- Figur 4e: ein fünfter Prozessschritt eines beispielhaften erfindungsgemäßen Prozesses,
- Figur 4f: ein sechster Prozessschritt eines beispielhaften erfindungsgemäßen Prozesses,
- Figur 4g: ein siebter Prozessschritt eines beispielhaften erfindungsgemäßen Prozesses,
- Figur 5: eine schematische Darstellung einer ersten erfindungsgemäßen beispielhaften Rolle-zu-Rolle Anlage und
- Figur 6: eine schematische Darstellung einer zweiten erfindungsgemäßen beispielhaften Rolle-zu-Rolle Anlage.

In den Figuren sind gleiche Bauteile oder Bauteile mit der gleichen Funktion mit den gleichen Bezugszeichen gekennzeichnet.

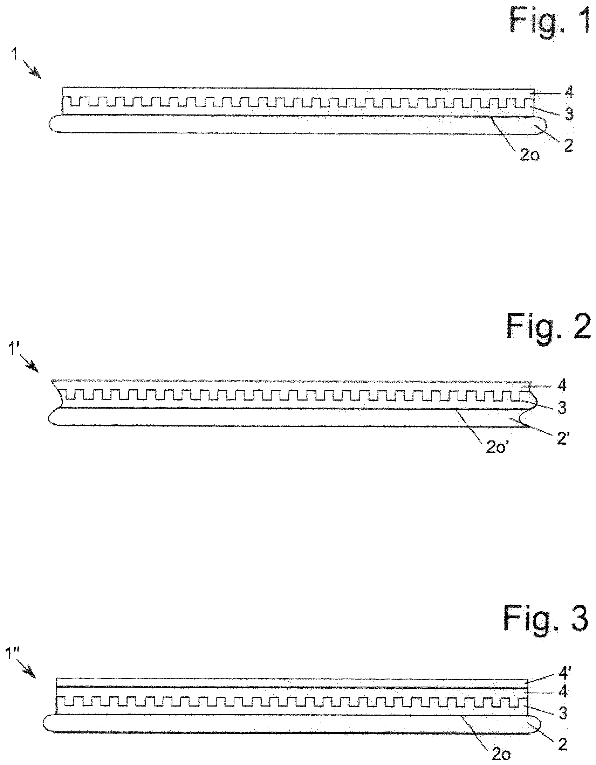

Die Figur 1 zeigt eine erste erfindungsgemäße Ausführungsform eines ersten erfindungsgemäßen Produkts 1, auf einem Substrat 2, insbesondere einem Wafer.

Die Figur 2 zeigt eine zweite erfindungsgemäße Ausführungsform eines zweiten erfindungsgemäßen Produkts 1', auf einem Substrat 2', insbesondere einer Folie. An der Substratoberfläche 2o' des Substrats 2' befindet sich eine, insbesondere strukturierte, schützenswerte Struktur 3. Bei der Struktur 3 kann es sich um Mikrochips, MEMs, Kavitäten, LEDs, Speicher insbesondere aber um Prägestrukturen handeln. Die Strukturen 3 sind mit einem erfindungsgemäßen Schutzmaterial 4 beschichtet.

Die Figur 3 zeigt eine dritte erfindungsgemäße Ausführungsform eines dritten erfindungsgemäßen Produkts 1", auf einem Substrat 2, insbesondere einem Wafer. An der Substratoberfläche 2o des Substrats 2 befindet sich eine, insbesondere strukturierte, schützenswerte Struktur 3. Bei der Struktur 3 kann es sich um Mikrochips, MEMs, Kavitäten, LEDs, Speicher insbesondere aber um Prägestrukturen handeln. Die Strukturen 3 sind mit einem erfindungsgemäßen ersten Schutzmaterial 4 beschichtet. Über dem erfindungsgemäßen ersten Schutzmaterial 4 befindet sich ein, insbesondere vom ersten Schutzmaterial 4 unterschiedliches, zweites Schutzmaterial 4`.

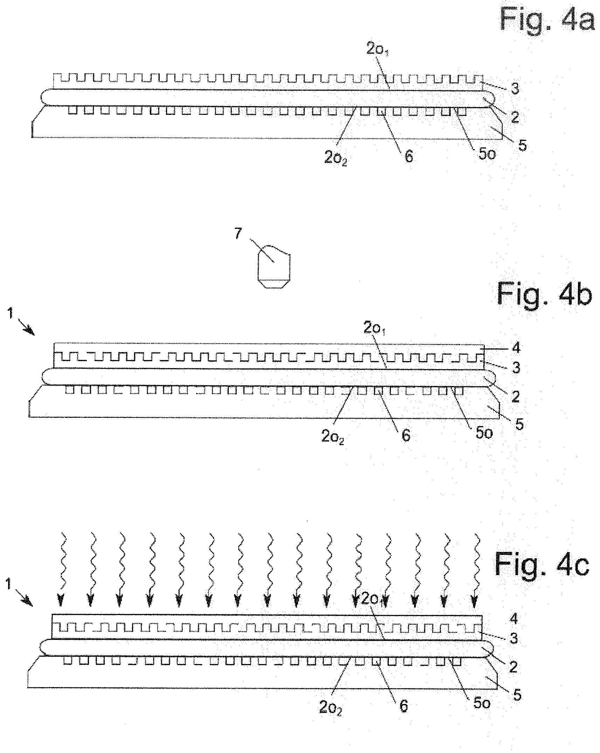

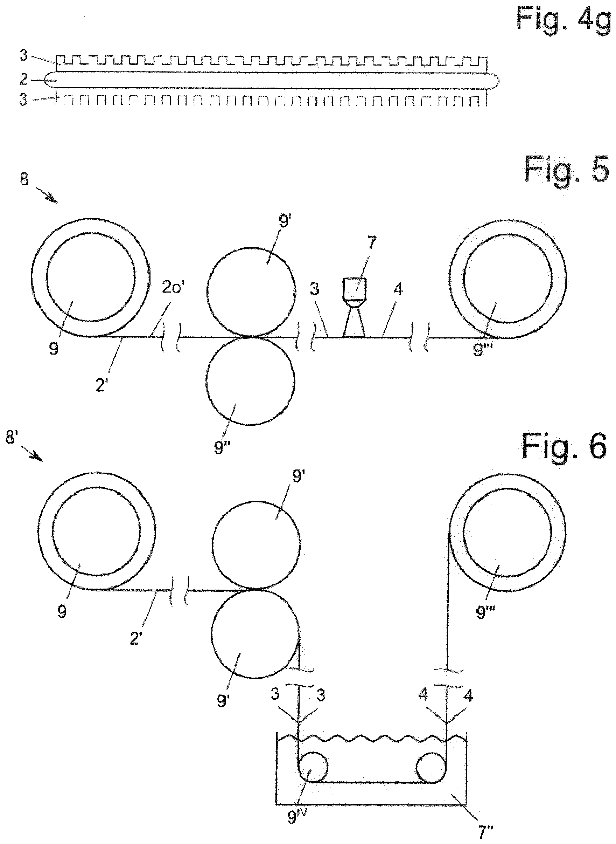

Die Figur 4a zeigt ein Substrat 2, insbesondere einen Wafer, mit einer schützenswerten, insbesondere strukturierten, Struktur 3 auf einer ersten Substratoberfläche 2o1 in einem ersten erfindungsgemäßen Prozessschritt. Das Substrat 2 ist dabei vorzugsweise mit seiner, der ersten Substratoberfläche 2o1 gegenüberliegenden, zweiten Substratoberfläche 2o2 auf einem Probenhalter 5 fixiert. Die Fixierung erfolgt dabei mit Hilfe von Fixiermitteln 6. Bei den Fixiermitteln handelt es sich vorzugsweise um eine Vakuumfixierung. Denkbar sind auch mechanische Fixierungen, elektrostatische Fixierungen, magnetische Fixierungen oder Fixierungen mittels, insbesondere schaltbarer, adhäsiver Oberflächen. Die schützenswerten, insbesondere geprägten, Strukturen 3 konnten insbesondere direkt nach der Fixierung des Substrats 2 auf dem Probenhalter 5 prozessiert und hergestellt werden.

Die Figur 4b zeigt einen erfindungsgemäßen zweiten Prozessschritt, bei dem ein erfindungsgemäßes Schutzmaterial 4 auf den schützenswerten, insbesondere geprägten, Strukturen 3 abgeschieden wird. Die bevorzugten erfindungsgemäßen Auftragungsverfahren sind die Schleuderbelackung und/oder die Sprühbelackung.

Die Figur 4c zeigt einen dritten Prozessschritt, einer chemischen und/oder physikalischen Modifikation des erfindungsgemäßen Schutzmaterials. Bei der chemischen und/oder physikalischen Modifikation handelt es sich insbesondere um einen Härtungsprozess.

Nach der chemischen und/oder physikalischen Modifikation kann das Substrat 2 mit seinem gehärteten Schutzmaterial 4 auf dem Probenhalter fixiert werden, sodass die zweite Substratoberfläche 2o2 prozessiert werden kann, sofern das notwendig und/oder erwünscht ist.

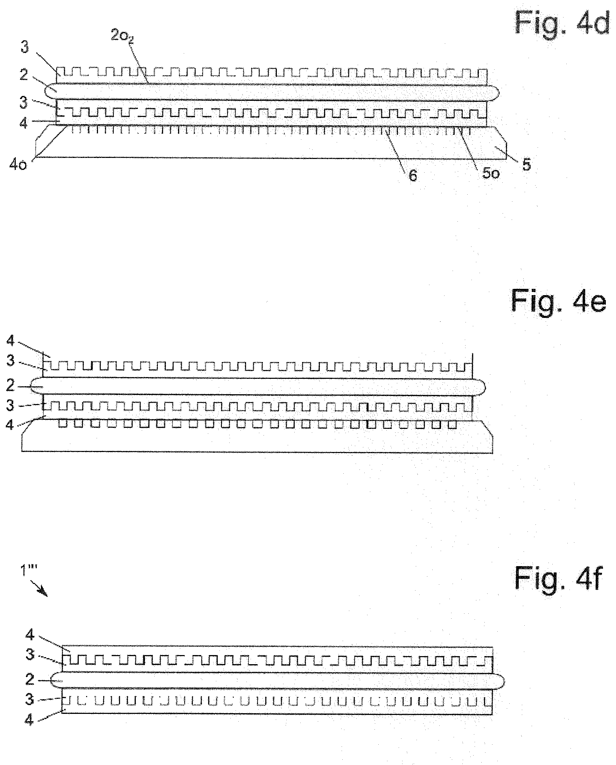

Durch den erfindungsgemäßen Schutz der Strukturen 3 mit Hilfe des Schutzmaterials 4 ist daher gemäß Figur 4d eine Fixierung der Schutzmaterialoberfläche 4o mit einem Probenhalter 5, insbesondere demselben Probenhalter wie in den vorherigen Prozessschritten, möglich. Das Schutzmaterial 4 schützt die Strukturen 3 durch alle Arten von Belastungen, die auf der Substratoberfläche 2o2 auftreten. Dazu zählen beispielsweise Ätzprozesse, Schleifprozesse, Polierprozesse, Strukturierungsprozesse, insbesondere Imprintprozesse. In einer ganz besonderen, erfindungsgemäßen Ausführungsform werden auf der zweiten Substratoberfläche wiederum Strukturen 3 geprägt, sodass man ein doppelseitig geprägtes Substrat erhält.

Nach der Bearbeitung der Strukturen 3 der zweiten Substratoberfläche 2o2 kann wiederum eine erfindungsgemäße Beschichtung zum Schutz der Strukturen gemäß Figur 4e erfolgen, sofern das notwendig ist. Eine Notwendigkeit ergibt sich vor allem bei einem Transport über lange, insbesondere über verunreinigte Strecken. Das erfindungsgemäße Schutzmaterial 4 dient daher nicht nur als mechanischer Stabilisator, sondern auch als Schutzschicht für, in der Atmosphäre und/oder Umgebung vorkommende Medien, insbesondere Fluide, noch spezifischer Flüssigkeiten oder Gase.

Das so entstandene, insbesondere doppelseitig bearbeitet, Produkt 1‴ gemäß Fig. 4f kann dann transportiert werden.

Die Figur 5 zeigt eine erste Ausführungsform einer Rolle-zu-Rolle Anlage 8, die ein erfindungsgemäßes Produkt herstellt. Das Substrat 2' wird von einer ersten Rolle 9 abgewickelt und mindestens einseitig an der Oberfläche 2o' prozessiert. Die Prozessierung kann beispielsweise durch eine Prägerolle 9' erfolgen, die auf der Substratoberfläche 2o' eine Struktur 3 prägt. Der Prägerolle 9' kann eine Gegendruckrolle 9" entgegengestellt sein. Die einseitig prozessierten Strukturen 3 des Substrats 2' werden in einem weiteren Prozessschritt durch ein Aufbringmittel 7 erfindungsgemäß geschützt. Danach erfolgen weitere, optionale Prozessschritte und schließlich eine Speicherung des Substrats 2' auf einer Speicherrolle/Aufwickelrolle 9‴.

Die Figur 6 zeigt eine zweite Ausführungsform einer Rolle-zu-Rolle Anlage 8', die ein erfindungsgemäßes Produkt herstellt. Das Substrat 2' wird von einer Rolle 9 abgewickelt und gelangt über Prozessierungseinheiten, insbesondere Prägerollen 9', in ein Aufbringmittel 7. Bei dem Aufbringmittel 7 ` handelt es sich vorzugsweise um ein Bad mit Transportrollen 9^{IV}. Denkbar ist allerdings auch eine zweiseitige Belackung mithilfe von Aufbringmittel 7, insbesondere Düsenvorrichtungen. Das, insbesondere beidseitig beschichtete, Substrat 2` wird dann wieder auf einer Rolle 9‴ aufgerollt und gespeichert.

Der Schutzbereich des Patents wird durch die Patentansprüche bestimmt.

### Bezugszeichenliste

- 1, 1', 1",1‴: Erfindungsgemäßes Produkt
- 2, 2': Substrat
- 2o, 2o': Substratoberflächen
- 2o1, 2o2: Substratoberflächen
- 3: Struktur
- 4, 4': Schutzmaterial
- 4o: Schutzmaterialoberfläche
- 5: Probenhalter
- 5o: Probenhalteroberfläche
- 6: Fixiermittel
- 7, 7': Aufbringmittel
- 8, 8': Rolle-zu-Rolle Anlage
- 9, 9', 9", 9‴ 9^{IV}: Rolle

## Patentansprüche

1. Verfahren zur Behandlung eines Substrats (2,2') mit Millimeter und/oder Mikrometer und/oder Nanometerstrukturen (3), wobei auf die Strukturen (3) mindestens ein Schutzmaterial (4, 4') aufgebracht wird, wobei das mindestens eine Schutzmaterial (4, 4') in einem Lösungsmittel lösbar ist, wobei das Substrat (2,2') eine erste Substratoberfläche (2o₁) und eine zweite Substratoberfläche (2o₂) aufweist, wobei die Millimeter- und/oder Mikrometer- und/oder Nanometerstrukturen (3) auf der ersten Oberfläche (2o₁) angeordnet sind, wobei die Millimeter- und/oder Mikrometer- und/oder Nanometerstrukturen (3) durch einen Imprintprozess hergestellt sind, wobei die erste Substratoberfläche (2o₁) mit dem aufgebrachten mindestens einen Schutzmaterial (4,4') auf einem Substrathalter(5) fixiert ist, wobei die zweite Substratoberfläche (2o2) bearbeitet wird, während die erste Substratoberfläche (2o1) auf den Substrathalter (5) fixiert ist.

2. Verfahren nach Anspruch 1, wobei das mindestens eine Schutzmaterial (4, 4') als mindestens eine Schutzschicht (4, 4') auf den Strukturen (3) angeordnet wird, wobei bevorzugt das mindestens eine Schutzmaterial (4, 4') vollständig die Strukturen (3) überdeckt.

3. Verfahren nach einem der vorhergehenden Ansprüche, wobei das mindestens eine Schutzmaterial (4, 4') durch Schleuderbelackung, Sprühbelackung, Laminierung und/oder Tauchen aufgebracht wird.

4. Verfahren nach einem der vorhergehenden Ansprüche, wobei das mindestens eine Schutzmaterial (4, 4') nach dem Aufbringen chemisch und/oder physikalisch modifiziert wird, wobei diese Modifikation insbesondere eine Härtung, eine Viskositätserhöhung und/oder eine Elastizitätssteigerung des mindestens einen Schutzmaterials (4, 4') umfasst.

5. Verfahren nach einem der vorhergehenden Ansprüche, wobei auf ein erstes aufgebrachtes Schutzmaterial (4) ein zweites, insbesondere vom Schutzmaterial (4) unterschiedliches, Schutzmaterial (4`) aufgebracht wird.

6. Verfahren nach einem der vorhergehenden Ansprüche, wobei mehrere, insbesondere unterschiedliche Schutzmaterialien (4, 4') aufweisende, übereinander angeordnete Schutzschichten (4, 4') über den Strukturen (3) angeordnet werden.

7. Verfahren nach einem der vorhergehenden Ansprüche, wobei das mindestens eine Schutzmaterial (4, 4') einen der folgenden Stoffe oder ein Gemisch der folgenden Stoffe umfasst:
• Paraffine, insbesondere
∘ Petrolatum
∘ Wachse
▪ Ceresin
• Polymere, insbesondere
∘ Photolacke allgemein
∘ Poly(methylmethacrylate)
∘ Poly(methylglutarimide)
∘ Phenolformaldehydeharze, insbesondere
▪ Bakelit
∘ Epoxide, insbesondere
▪ SU-8
∘ Polyimide
∘ Polyamide
∘ Silane
∘ Silikone
∘ PDMS (Schutzfolie und abziehen)
∘ PFPE
∘ Akrylate

8. Verfahren nach einem der vorhergehenden Ansprüche, wobei das mindestens eine Schutzmaterial (4, 4') einen der folgenden Stoffe oder ein Gemisch der folgenden Stoffe umfasst:
• Polyvinylalkohol
• Polyether, insbesondere
o Polyethylenglykol
• Celluloseether
• Poly(2-ethyl-2-oxazoline)
• Alkohole, insbesondere
∘ Glycerin, insbesondere
▪ Fette, insbesondere
• Triacylglycerine
• Zucker
• Carbonsäureverbindungen in Kunststoffen
• Benzotriazol

9. Verfahren nach einem der vorhergehenden Ansprüche, wobei das mindestens eine Schutzmaterial 4,4' durch eines der folgenden Lösungsmittel oder durch ein Lösungsmittelgemisch der folgenden Lösungsmittel lösbar ist:
• Alkane
• Alkene
• Alkine
• Aromaten, insbesondere
∘ Benzol
• Carbonsäureester
• Ether, insbesondere
∘ Diethylether
• Tetramethylsilan
• Tetrachlorwasserstoff
• Kohlenstoffdisulfid
• Benzin
• Chloroform
• Gase, insbesondere
∘ Kohlenmonoxid

10. Verfahren nach einem der vorhergehenden Ansprüche, wobei das mindestens eine Schutzmaterial 4,4' durch eines der folgenden Lösungsmittel oder durch ein Lösungsmittelgemisch der folgenden Lösungsmittel lösbar ist:
• Wasser
• Alkohole, insbesondere
∘ Methanol, Ethanol
• Ketone, insbesondere
∘ Aceton
• Amine, insbesondere
∘ Primäre und sekundäre Amine
• Lactone
• Lactame
• Nitrile
• Nitroverbindungen
• Tertiäre Carbonsäureamide
• Harnstoffderivate
• Sulfoxide
• Sulfone, insbesondere
∘ Sulfolan
• Kohlensäureester, insbesondere
∘ Dimethylcarbonat
∘ Ethylencarbonat
• Säuren, insbesondere
∘ Mineralsäuren, insbesondere
▪ Schwefelsäure
▪ Halogenwasserstoffsäuren
∘ Organische Säuren, insbesondere
▪ Carbonsäuren, insbesondere
• Ameisensäure, Essigsäure
• Basen, insbesondere
∘ NaOH, KOH
• Gase
∘ Wasserstoff
∘ Sauerstoff
∘ Stickstoff

11. Verfahren zur Bearbeitung eines Substrats (2,2'), insbesondere einer Folie (2'), aufweisend mindestens die folgenden Schritte:
a) Abgabe des Substrats (2,2') von einer Abgabeeinheit (9),
b) Aufbringung und/oder Anordnung, insbesondere beidseitig des Substrats (2,2'), von Millimeter und/oder Mikrometer und/oder Nanometerstrukturen (3) auf dem Substrat (2,2'),
c) Aufbringung, insbesondere beidseitig des Substrats (2,2'), mindestens eines Schutzmaterials (4,4') mit einem Verfahren gemäß einem der vorhergehenden Ansprüche auf die Strukturen (3),
d) Aufnahme des Substrats (2,2') von einer Speichereinheit (9‴).

## Claims

1. A method for the treatment of a substrate (2, 2') with millimetre and/or micrometre and/or nanometre structures (3), wherein at least one protective material (4, 4') is applied on the structures (3), wherein at least one protective material (4, 4') is soluble in a solvent, wherein the substrate (2, 2') comprises a first substrate surface (2o₁) and a second substrate surface (2o₂), wherein the millimetre and/or micrometre and/or nanometre structures (3) are arranged on the first surface (2o₁), wherein the millimetre and/or micrometre and/or nanometre structures (3) are produced by an imprint process, wherein the first substrate surface (2o₁) is fixed with the applied at least one protective material (4, 4') on a substrate holder (5), wherein the second substrate surface (2o₂) is treated, whilst the first substrate surface (2o₁) is fixed on the substrate holder (5).

2. The method according to claim 1, wherein the at least one protective material (4, 4') is arranged as at least one protective layer (4, 4') on the structures (3), wherein the at least one protective material (4, 4') preferably completely covers the structures (3).

3. The method according to any one of the preceding claims, wherein the at least one protective material (4, 4') is applied by spin coating, spray coating, lamination and/or dip coating.

4. The method according to any one of the preceding claims, wherein the at least one protective material (4, 4') is chemically and/or physically modified after the application, wherein this modification comprises in particular curing, increasing viscosity and/or increasing elasticity of the at least one protective material (4, 4').

5. The method according to any one of the preceding claims, wherein a second protective material (4'), in particular different from the protective material (4), is applied on a first applied protective material (4).

6. The method according to any one of the preceding claims, wherein a plurality of protective layers (4, 4'), arranged above one another, in particular comprising different protective materials (4, 4'), are arranged above the structures (3).

7. The method according to any one of the preceding claims, wherein the at least one protective material (4, 4') comprises one of the following substances or a mixture of the following substances:
• paraffins, in particular
∘ petrolatum
∘ waxes
▪ ceresin
• polymers, in particular
∘ photoresists general
∘ poly(methylmethacrylate)
∘ poly(methylglutarimide)
∘ phenol formaldehyde resins, in particular
▪ bakelite
∘ epoxides, in particular
▪ SU-8 a
∘ polyimides
∘ polyamides
∘ silanes
∘ silicones
∘ PDMS (protective film and removal)
∘ PFPE
∘ acrylates

8. The method according to any one of the preceding claims, wherein the at least one protective material (4, 4') comprises one of the following substances or a mixture of the following substances:
• polyvinyl alcohol
• polyether, in particular
∘ polyethylene glycol,
• cellulose ether
• poly(2-ethyl-2-oxazoline)
• alcohols, in particular
∘ glycerine, in particular
▪ fats, in particular
• triacylglycerides
• sugar
• carboxylic acid compounds in plastics
• benzotriazole

9. The method according to any one of the preceding claims, wherein the at least one protective material (4, 4') is soluble by one of the following solvents or by a solvent mixture of the following solvents:
• alkanes
• alkenes
• alkines
• aromatic compounds, in particular
∘ benzene
• carboxylic acid ester
• ether, in particular
∘ diethyl ester
• tetramethyl silane
• hydrogen tetrachloride
• carbon disulphide
• benzene
• chloroform
• gases, in particular
∘ carbon monoxide

10. The method according to any one of the preceding claims, wherein the at least one protective material (4, 4') is soluble by one of the following solvents or by a solvent mixture of the following solvents:
• water
• alcohols, in particular
∘ methanol, ethanol
• ketones, in particular
∘ acetone
• amines, in particular
∘ primary and secondary amines
• lactone
• lactam
• nitriles
• nitro compounds
• tertiary carboxylic acid amides
• urea derivatives
• sulphoxides
• sulphones, in particular
∘ sulfolane
• carboxylic acid ester, in particular
∘ dimethyl carbonate
∘ ethylene carbonate
• acids, in particular
∘ mineral acids, in particular
▪ sulphuric acid
▪ halogen hydracids
∘ organic acids, in particular
▪ carboxylic acids, in particular
• formic acid, acetic acid
• bases, in particular
∘ NaOH, KOH
• gases
∘ hydrogen
∘ oxygen
∘ nitrogen

11. A method for the treatment of a substrate (2, 2'), in particular a film (2'), comprising at least the following steps:
a) delivery of the substrate (2, 2') by a delivery unit (9),
b) application and/or arrangement, in particular on both sides of the substrate (2, 2'), of millimetre and/or micrometre and/or nanometre structures (3) on the substrate (2, 2'),
c) application, in particular on both sides of the substrate (2, 2'), of at least one protective material (4, 4') with a method according to any one of the preceding claims on the structures (3),
d) admission of the substrate (2, 2') by a storage unit (9‴).

## Revendications

1. Procédé de traitement d'un substrat (2, 2') comportant des structures millimétriques et/ou micrométriques et/ou nanométriques (3), au moins un matériau protecteur (4, 4') étant appliqué sur les structures (3), l'au moins un matériau protecteur (4, 4') étant soluble dans un solvant, le substrat (2, 2') présentant une première surface de substrat (2o1) et une seconde surface de substrat (202), les structures millimétriques et/ou micrométriques et/ou nanométriques (3) étant appliquées sur la première surface (2o1), les structures millimétriques et/ou micrométriques et/ou nanométriques (3) étant réalisées par un processus d'impression, la première surface de substrat (2o1) étant fixée avec l'au moins un matériau protecteur (4, 4') appliqué dessus sur un support de substrat (5), la seconde surface de substrat (202) étant traitée pendant que la première surface de substrat (2o1) est fixée sur le support de substrat (5).

2. Procédé selon la revendication 1, dans lequel l'au moins un matériau protecteur (4, 4') est disposé sous forme d'au moins une couche protectrice (4, 4') sur les structures (3), l'au moins un matériau protecteur (4, 4') recouvrant complètement les structures (3).

3. Procédé selon une des revendications précédentes, dans lequel l'au moins un matériau protecteur (4, 4') set appliqué par vernissage centrifuge, vernissage par pulvérisation, laminage et/ou trempage.

4. Procédé selon une des revendications précédentes, dans lequel l'au moins un matériau protecteur (4, 4') est modifié chimiquement/ou physiquement après application, cette modification comprenant en particulier un durcissement, une augmentation de viscosité et/ou un accroissement d'élasticité de l'au moins un matériau protecteur (4, 4').

5. Procédé selon une des revendications précédentes, dans lequel, sur un premier matériau protecteur appliqué (4), un second matériau protecteur (4'), en particulier différent du matériau protecteur (4), est appliqué.

6. Procédé selon une des revendications précédentes, dans lequel des couches protectrices (4, 4'), présentant en particulier plusieurs matériaux protecteurs (4, 4') superposés, sont disposées sur les structures (3). ;

7. Procédé selon une des revendications précédentes, dans lequel l'au moins un matériau protecteur (4, 4') comprend une des substances suivantes ou un mélange des substances suivantes :
• des paraffines, en particulier
∘ de la vaseline
∘ des cires
• de la cérésine
• des polymères, en particulier
∘ des résines thermosensibles de manière générale
∘ des poly(méthylméthacrylates)
∘ des résines de phénol formaldéhyde, en particulier
▪ de la bakélite
∘ des époxydes, en particulier
▪ du SU-8
∘ des polyimides
∘ des polyamides
∘ des silanes
∘ des silicones
∘ des PDMS (film protecteur et retrait)
∘ des PFPE
∘ des acrylates

8. Procédé selon une des revendications précédentes, dans lequel l'au moins un matériau protecteur (4, 4') comprend une des substances suivantes ou un mélange des substances suivantes :
• de l'alcool de polyvinyle
• des polyéthers, en particulier
∘ du polyéthylène glycol
• des éthers de cellulose
• du poly(2-éthyle-2-oxazoline)
• des alcools, en particulier
∘ de la glycérine, en particulier
▪ des graisses, en particulier
• des triacylglycérines
• du sucre
• des composés d'acide carboxylique dans des matières plastiques
• du benzotriazole.

9. Procédé selon une des revendications précédentes, dans lequel l'au moins un matériau protecteur (4, 4') est soluble par un des solvants suivants ou par un mélange de solvants composé des solvants suivants :
• alcanes
• alkènes
• alkines
• aromates, en particulier
∘ benzène
• esters d'acide carboxylique
• éthers, en particulier
∘ diéthyléthers
• tétraméthysilane
• tétrachlorure d'hydrogène
• disulfure de carbone
• essence
• chloroforme
• gaz, en particulier
∘ monoxyde de carbone.

10. Procédé selon une des revendications précédentes, dans lequel l'au moins un matériau protecteur (4, 4') est soluble par un des solvants suivants ou par un mélange de solvants composé des solvants suivants :
• eau
• alcools, en particulier
∘ méthanol, éthanol
• cétones, en particulier
∘ acétone
• amines, en particulier
∘ amines primaires et secondaires
• lactones
• lactames
• nitriles
• nitrocomposés
• amides d'acide carbonique tertiaires
• dérivés d'urée
• sulfoxydes
• sulfones, en particulier
∘ sulfolane
• esters de l'acide carbonique, en particulier
∘ carbonate de diméthyle
∘ carbonate d'éthylène
• acides, en particulier
∘ acides minéraux, en particulier
▪ acide sulfurique
▪ acides halogénohydriques
∘ acides organiques, en particulier
▪ acides carboxyliques, en particulier
• acide formique, acide acétique
• bases, en particulier
∘ NaOH, KOH
• gaz
∘ hydrogène
∘ oxygène
∘ azote

11. Procédé de traitement d'un substrat (2, 2'), en particulier d'un film (2') présentant au moins les étapes suivantes :
a) prélèvement du substrat (2, 2') dans une unité de distribution (9),
b) application et/ou disposition, en particulier des deux côtés du substrat (2, 2'), de structures millimétriques et/ou micrométriques et/ou nanométriques (3) sur le substrat (2, 2'),
c) application, en particulier des deux côtés du substrat (2, 2'), d'au moins un matériau protecteur (4, 4') par un procédé selon une des revendications précédentes sur les structures (3),
d) prise en charge du substrat (2, 2') par au moins une unité de stockage (9"').
